(19) Europäisches Patentamt

European Patent Office

Office européen des brevets

(11) Publication number: **0 183 476 B1**

# EUROPEAN PATENT SPECIFICATION

(45) Date of publication of patent specification: **06.11.91**   (51) Int. Cl.⁵: **G11C 17/00**

(21) Application number: **85308426.7**

(22) Date of filing: **19.11.85**

(54) MOS read-only memory systems.

(30) Priority: **19.11.84 JP 245586/84**
       **28.11.84 JP 251046/84**

(43) Date of publication of application:
   **04.06.86 Bulletin 86/23**

(45) Publication of the grant of the patent:
   **06.11.91 Bulletin 91/45**

(84) Designated Contracting States:
   **DE FR GB**

(56) References cited:
   **EP-A- 0 020 054**
   **EP-A- 0 045 610**
   **EP-A- 0 105 105**

(73) Proprietor: **Oki Electric Industry Company,
Limited
7-12, Toranomon 1-chome Minato-ku
Tokyo 105(JP)**

(72) Inventor: **Kitazawa, Shooji
Oki Electric Ind. Co. Ltd. 7-12, Toranomon
1-chome
Minato-ku Tokyo(JP)**

(74) Representative: **Boydell, John Christopher et
al
Stevens, Hewlett & Perkins 1 Serjeants' Inn
Fleet Street
London EC4Y 1LL(GB)**

**Description**

The present invention relates to a read-only memory system (hereinafter simply called ROM) such as a mask ROM and a PROM, more particularly to a MOS ROM circuit having a read and sense amplifier.

Japanese Laid-Open Patent Publications No. 59-75495 and No. 59-77700, and Japanese Patent Publication No. 59-13117, disclose such prior ROM IC devices.

With the increasing packing density of MOS ROM IC devices, it has been difficult to access the contents of a selected memory cell at and near the ends of the word lines at a high rate, because of the larger capacitance associated with the word lines. For example, in a 256-bit EPEOM IC in which polysilicon word lines are used, the access delay due to the word lines occupies one third or more of the whole access time, resulting in a decreased read-out speed.

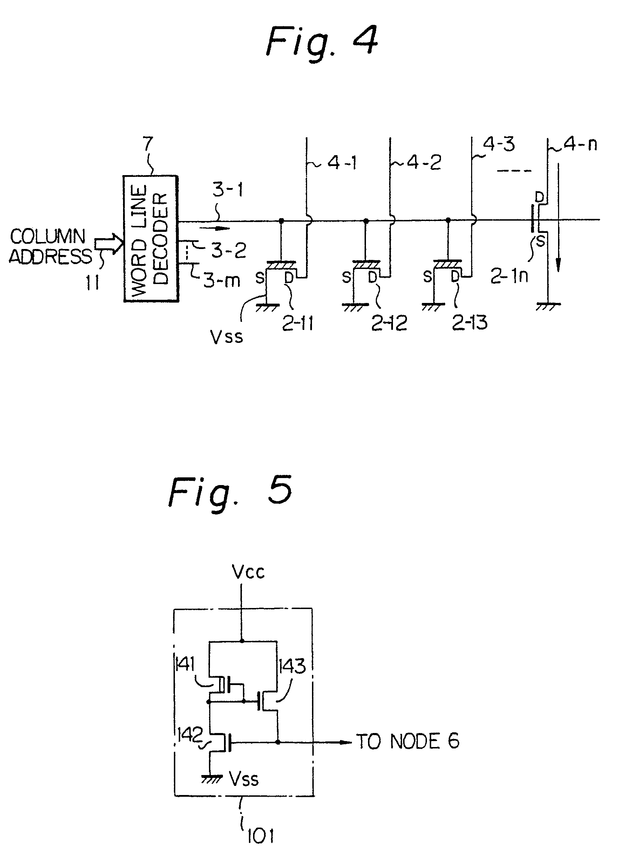

The problem will be described in detail with reference to Figure 4 of the accompanying drawings. In general, the prior MOS ROM IC device employs memory MOS transistors in each of which the source is connected to ground (Vss). Now, for example, in a read operation, when a word line decoder 7 selects a word line 3-1 in response to a column address signal 11 while a data line decoder (not shown) selects a data line 4-n in response to a row address signal 12, a memory MOS transistor 2-1n becomes conductive, so that a detection current flows from its drain electrode to its source electrode. Meanwhile, the remaining MOS transistors, which are not selected, form inversion layers under the gate insulating layers thereof, thus resulting in a MOS capacitance, determined only by the thickness of the gate insulating layer, being presented to the data line.

This MOS capacitance is very large and forms an RC ladder delay circuit with the resistance content of the word line. In the following read operation, when one of the remaining MOS transistors is selected, the word line decoder has to drive a selected word line acting as a heavy load, so that the read-out speed is greatly decreased due to the delay characteristics of the word line.

The present invention seeks to provide an improved MOS ROM system capable of reading stored contents therein at a high rate, and including an improved read and sense amplifier.

According to the invention, there is provided a MOS ROM system comprising a memory matrix having a plurality of memory cells, a plurality of data lines and a plurality of word lines, said data lines and said word lines being arranged in a matrix form, said memory cells each being formed of a MOS transistor which has a gate electrode connected to said word line, a source electrode connected to said data line and a drain electrode connected to a common line; a word line decoder for selecting one of said word lines in response to a column address signal to activate a selected MOS transistor; a multiplexer including a plurality of MOS switching transistors being connected to said data lines of said memory matrix; a data line decoder for activating one of said MOS switching transistors in response to a row address signal to select one of said data lines; a read and sense circuit connected to said multiplexer; said system being characterised by a power supply means connected to said common line of said memory matrix for providing a first potential; and load means connected between said data line and said power supply means for suppressing the voltage drop of said data line; and in that said read and sense circuit has a sense node at a second potential lower than said first potential, said sense node being connected to said multiplexer for amplifying a detection current passing through a selected MOS transistor of said memory matrix to deliver a data signal.

The features of the first part of claim 1 are known from EP-A-0 105 105.

In an embodiment, said read and sense circuit comprises a converter for converting the data detection curent into voltage, a reference voltage circuit for generating a reference voltage, a differential amplifier for amplifying an output difference between the converter and the reference voltage circuit, and an output circuit for amplifying an output signal from the differential amplifier to deliver the data signal to a data output terminal. In the present invention detection current flows from a selected data line to the read and sense circuit during a read operation.

In order that the invention may be better understood, several embodiments thereof will now be described by way of example only and with reference to the accompanying drawings in which:-

Figure 1 is a block diagram illustrating an embodiment of the MOS ROM system of the present invention;

Figure 2 is a circuit diagram of a read and sense circuit used in the ROM system in Figure 1;

Figure 3 is a view showing the operation of the memory cell transistors in Figure 1;

Figure 4 is a view showing the operation of the memory cell transistors of a prior MOS ROM system;

Figure 5 is a circuit diagram showing another embodiment of a voltage reducing circuit used in the read and sense circuit in Figure 2;

Figure 6 is a second embodiment of a current sense circuit used in the read and sense circuit in Figure 2; and

Figure 7 is a third embodiment of a current sense circuit used in the read and sense circuit in Figure 2.

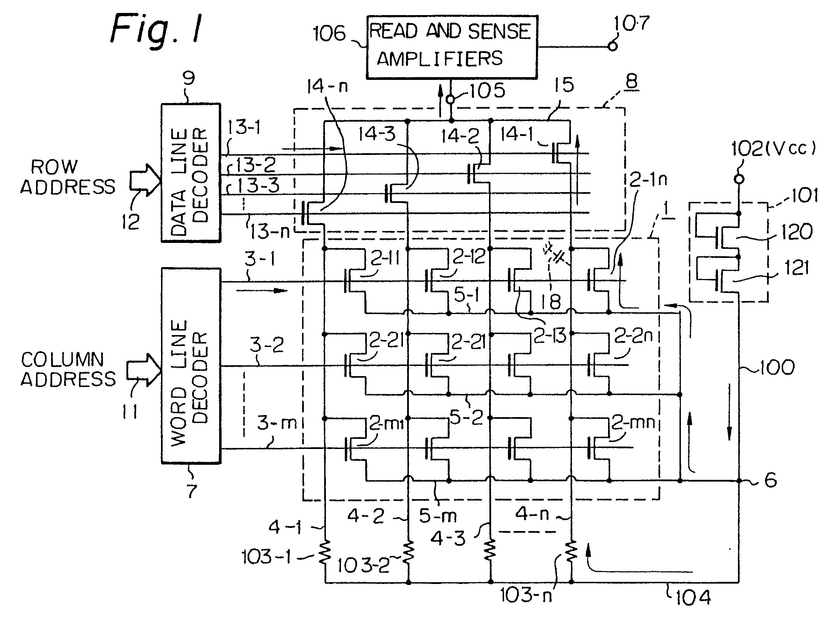

A MOS ROM system according to the present invention will be described below with reference to Figures 1 to 3.

As shown in Figure 1, a memory cell matrix includes memory cells 2-11--2-1n, ...., 2-m1--2-mn arranged in the form of a matrix 1. Each memory cell comprises, for example, an N-channel MOS transistor. A plurality of word lines 3-1--3-m made of poly silicon, etc., are disposed in a row direction of the memory cell matrix 1, while a plurality of data lines 4-1--4-n made of aluminium, etc., are arranged in a column direction of the same. Each of the word lines 3-1--3-m is connected with a gate of each of the memory cells 2-11--2-1n, ...., 2-m1--2-mn in the row direction, while each of the data lines 4-1--4-n is connected with a drain of each of the memory cells 2-11--2-m1, ...., 2-1n--2-mn in the column direction. The sources of the memory cells 2-11--2-m1, ...., 2-1n--2-mn in the row direction are respectively connected with common lines 5-1--5-m.

The respective word lines 3-1--3-m are connected with a word line decoder 7, while the respective data lines 4-1--4-n are connected with a data line decoder 9 and a read and sense circuit 106 via a multiplexer 8. The word line decoder 7 and the data line decoder 9 decode column and row address signals 11, 12, and provide respective single line selection signals. Therebetween, the word line decoder 7 decodes the input signal 11 to provide the selection signal to any of the word lines 3-1--3-m. The data line decoder 9 is connected with the multiplexer 8 via a plurality of output lines 13-1--13-n, to provide a decoded selection signal to the multiplexer 8 via any of the output lines 13-1--13-n. The multiplexer 8 selects one of a plurality of the data lines, and has a plurality of MOS switching elements 14-1--14-n. Gates of these switching elements 14-1--14-n are connected with the respective output lines 13-1--13-n, and sources thereof connected with the respective data lines 4-n--4-1 while drains thereof connect with the read and sense circuit 106 via the common line 15 and a terminal 105.

Accordingly, when the selection signal from the data line decoder 9 is provided to a specific output line 13, the switching elements, selected in the multiplexer 8 is switched on, and thereby the data line connected with the gate electrode of the selected switching element is connected with the read and sense circuit 106.

The read and sense circuit 106 is operable to detect memory conditions (for example, conduction or non-conduction of the memory cell transistor of the memory cell selected in the memory cell matrix 1), and allows a supply current to flow to a memory cell selected by the data line decoder 9, the multiplexer 8, and the word line decoder 7 via the data lines 4-1--4-n and the common lines 5-1--5-n, and thereby detects the memory state of the selected memory cell and provides this as readout data from a data output terminal 107 to the outside. The conduction or non-conduction of the memory cell is distinguished by changing the presence of wiring to each memory cell and shapes or electrical properties of a MOS transistor into at least two states thereof. Accordingly, any data is previously written in the memory cell with use of the distinguished result. The numeral 18 in Figure 1 shows stray capacitance which is present on the respective data lines 4-1--4-n.

Furthermore, the read and sense circuit 106 senses the condition of a selected memory cell 2 by receiving a detection current I to deliver an output data signal to the terminal 107.

A voltage reducing circuit 101 is connected between a power source terminal 102 and a common line 5 to provide an intermediate potential (for example, +3V) between a higher potential Vcc and a lower potential Vss to the node 6. This suppresses the voltage amplitude on the data lines 4-1, ...., 4-n to a desired value due to the switch switching operation of the memory cells, thereby preventing increased power consumption as well as reduced signal transfer rate.

Resistances 103-1, 103-2, ...., 103-n are connected between the node 6 and the other ends of the data line due to a leakage current through the PN junctions of the memory cells connected with the non-selected data lines 4-1, ...., 4-n.

Accordingly, the resistors 103-1--103-n are selected to have a sufficient resistance value as compared with the current drive capacity of the memory cells 2-11--2-mn.

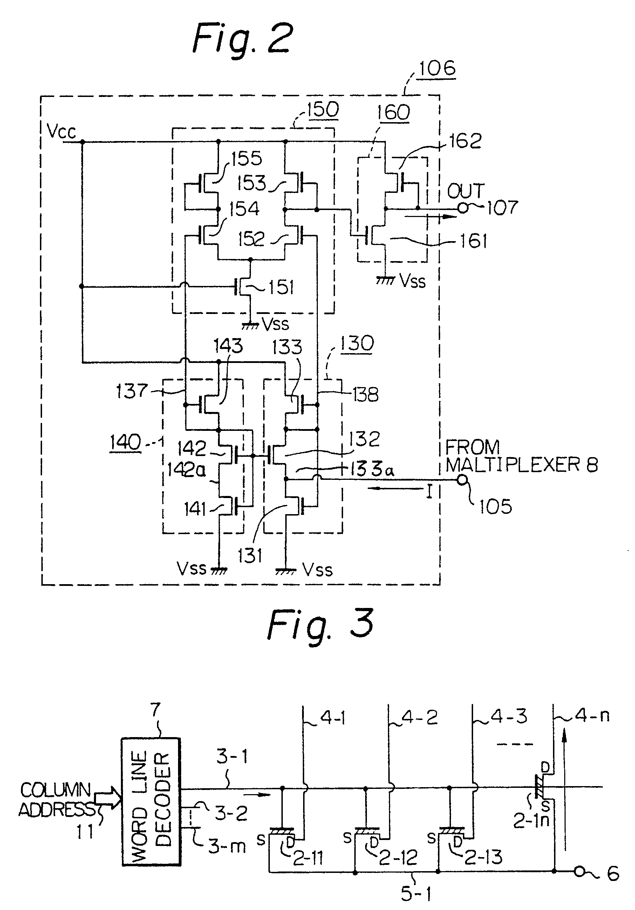

As shown in Figure 2, the read and sense circuit 106 comprises a converter 130 for converting a detection current provided from the input terminal 105 to voltage, a reference voltage circuit 140 for producing reference voltage for the converter 130, a differential amplifier 150 for amplifying an output voltage difference between the converter 130 and the reference voltage circuit 140, and an output circuit 160 for amplifying an output signal from the differential amplifier 105 to deliver the data signal to the data output terminal 107.

The converter 130 comprises enhancement type MOS transistors 131, 132 and a depletion type MOS transistor 133 serially connected with each other, in which the input terminal 105 of the converter is connected with the drain electrode side of the MOS transistor 131, while the source and gate electrodes of the MOS transistor 133 are connected with each other. The reference voltage circuit 140 comprises enhancement type MOS transistors 141, 142 and a depletion type MOS transistor 143 serially connected with each other, in which the drain of the MOS transistor 142 is connected with the gates of the MOS transistors 141, 142, 143 and 132, respectively.

In the converter 130 and the reference voltage circuit 140, the curent drive capability of the MOS transistor 131 is selected to be higher than that of the MOS transistor 141, while the MOS transistors 132, 142, and 133, 143 are adapted to have the same characteristics. The sources of the MOS transistors 131, 141 are kept at the supply voltage Vss, while the supply voltage Vcc is applied to the drains of the MOS transistors 133, 143. Furthermore, the potential of the gate electrode of the MOS transistor 133 varies in response to memory conditions within the memory cells 2-11--2-mn. A constant voltage can be obtained at the gate electrode of the MOS transistor 143. The voltage on the gate of the MOS transistor 143 is a constant voltage portion is compared with that of the data line.

The differential amplifier 150 comprises MOS transistors 151, 152, 153, 154 and 155. The supply voltage Vcc is applied to the gate of the MOS transistor 151, and the supply voltage Vss applied to the source thereof. The gates of the respective MOS transistors 152, 154 are respectively connected to the gate electrodes of the MOS transistors 133 and 143. The voltage difference between the terminals 137, 138 is amplified through MOS transistors 152, 154, and outputted to an output 160. The inverter 160 comprises an enhancement type MOS transistor 161 and a depletion type load MOS transistor 162 serially connected. The output voltage from the differential amplifier 150 is amplified by the MOS transistor 161 to supply a data output terminal 107.

The operation of the MOS ROM system will be described below with reference to Figures 1, 2 and 3. In Figure 1, the word lines 3-1 and the data lines 4-n, for example, are respectively selected by the word line decoder 7 and the data line 4-1--4-n in response to row and column address signals. A data line which has been selected until just before the present selection is made will be at a potential near the supply voltage Vss since the data line is in conduction with the read and sense circuit 106. A newly selected data line 4-n rapidly approaches Vss after the selection has been made, but all the other non-selected data lines 4-1--4(n-1) are the same in potential as that of the node 6 since they are not connected with the read and sense circuit 106. The potential of the node 6 lies between Vcc and Vss, so that if Vcc = +5v, Vss = 0, it is about +3V. For example, in a 256-kbit, 8 data output MOS ROM, 62. Non-selected data lines are at about 3V.

Although the potential of the word line 3-1 selected in this situation rises, if the respective memory cells 2-11--2-mn each comprise enhancement type MOS transistors, each of the MOS transistors does not begin to form a channel until its potential rises to ($V_T$ + 3V), assuming the threshold voltage of each of the MOS transistors to be $V_T$. Therefore, the electric charges required for raising the potential to that point are few and are confined to those required for forming a depletion layer under the gate oxide film of the MOS transistor and those for charging the gate capacitance against the source and drain of the MOS transistor in drain of the MOS transistor in current interruption.

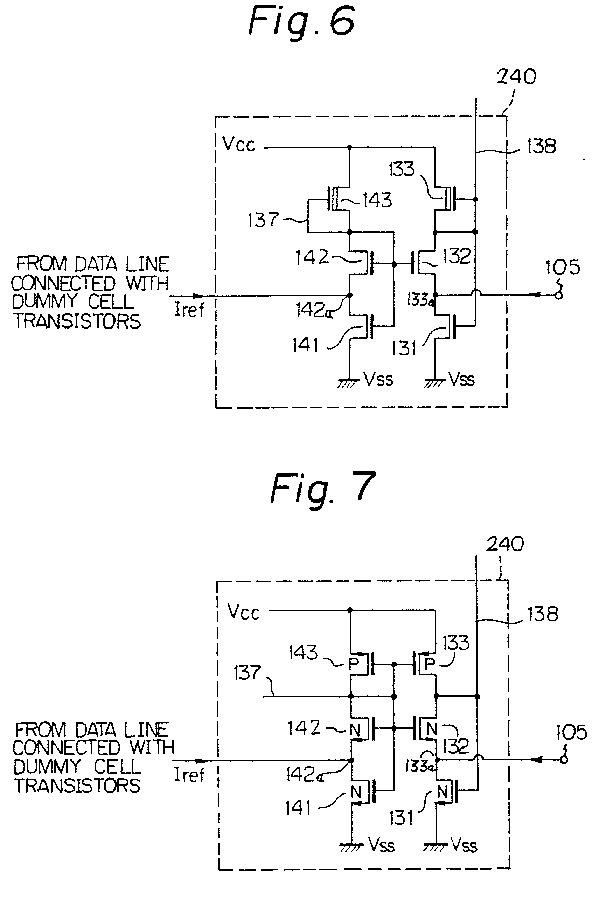

Actually, the enhancement type MOS transistor constituting each of the memory cells 2-11--1-mn is conspicuously subjected to a substrate effect due to the influence of a high concentration of impurity below the transistor isolating oxide film because of the narrow channel effect of the MOS transistor. Accordingly, in the situation of the potential ($V_T$ + 3V) as described above, the semiconductor substrate 20 of the MOS transistor is subjected to 3V of substrate bias, so that the threshold voltage ranges from 1 to 2V, particularly from 2 to 3V in an electrically writable EPROM. Thus, in practice, in each of the MOS transistors of the non-selected memory cells 2-11--2-1(n-1), formation of the channel is small even if the word 3-1 rises to the supply voltage Vcc. Accordingly, as shown in Figure 6, since the non-selected memory cells 2-11--2-1(n-1) do not act as a load capacitance to the word line 3-1, the capacitance is considerably reduced, greatly improving its signal transfer rate.

In addition, the MOS transistor constituting each of the selected memory cell 2-1n is switched on to conduct to the read and sense circuit 106, and the source potential thereof becomes about the voltage Vss. Accordingly, current flows from the drain of this MOS transistor via its source electrode to the read and sense circuit 106 which detects the contents stored in the selected memory cell 2-1(n-1) based on the amount of inflow current. Since the source potential of the memory cell 2-1n is substantially equal to Vss in such a manner, the current drive capacity of the sense amplifier is equivalent to that of the prior current outflow type sensing system as shown in Figure 2. Thus, the amount of a current to be detected by the read and sense circuit 106 is the same as that of the prior one.

Further, upon detecting the inflow current, unless the potential to be detected is sufficiently suppressed, it is impossible to assure the same amount of a current from the memory cell 2-1n as that of the prior system. However, according to the read and sense circuit 106 of the present invention constructed for example as shown in Figure 2, the detected potential can be dropped to about (Vss + 0.1V).

Namely, in the circuit of Figure 2, the input terminal 105 is connected with a data line, e.g., 4-n, selected by the data line decoder 9. If there is no inflow current from the input terminal 105, the potential of the terminal 133a is slightly low as compared with that of the terminal 142a. In contrast, if there is any inflow current from the terminal 105, the drain potential of the MOS transistor 131 rises slightly and becomes higher than that of the terminal 142a. Accordingly, a desired data output is realized at terminal 107 by amplifying such a voltage difference through the differential amplifier 150 and the inverter 160.

Further, it is feared in switching the data lines 3-1--3-n by the data line decoder 7 that many electric charges exist in the stray capacitance of the data line to be selected before the switching flow into the first read and sense circuit from the input terminal and this results in severe potential rise. Since such a potential rise may cause erroneous operation of the read and sense circuit 106, it is necessary to quickly emit the charges and quickly lower the raised potential. In the read and sense circuit shown in Figure 2, if a potential rise beyond a typical detection level (e.g. 0.1V) is produced on the input terminal 105, the potential of the terminal 133a is greatly raised, and thereby the MOS transistor 131 quickly increases its current drive capacity. Then, the potential of the terminal 105 is dropped to the typical detection level in a short time, so that the erroneous operation of the read and sense circuit 106 can be prevented.

In the present first embodiment, the potential of a non selected data line, e.g. 4-1--4-1(n-1) is adapted to lie between Vcc and Vss, while the potential of a selected word line, e.g. 3-1 adapted to be high. Accordingly, the gates and the sources of the non-selected memory cells 2-11--2-1(n) become together high potential to prevent channels being formed. Namely, the non-selected memory cells 2-11--2-1(n-1) do not serve as a load capacitance on the selected word line 3-1. Since the load capacitance of the selected word line 3-1 is reduced, the signal transfer rate through the word line 3-1 is made high, so that high speed readout from the ROM can be achieved. Further, since the load capacitance of the selected word line 3-1 is reduced, the capacitance of a driver in the word line decoder 7 for supplying electric charges to the selected word line 3-1 can be designed with ease and current consumption can be reduced.

In addition, in this embodiment, if the voltage reducing circuit 101 is not employed, the potential of the non-selected data line becomes Vcc, which is higher than the middle potential between Vcc and Vss. Thereupon, a potential amplitude on the data line is increased as the potential of the non-selected data line becomes high. Although the readout rate is slightly slowed down corresponding to the above increased potential amplitude, the circuit configuration can be simplified. Similarly, if the resistors 103-1--103-n are not employed, the potential of a non-selected data line is lowered due to current leakage in the non-selected memory cell, but since the readout rate can be raised, it is not harmful and allows the circuit configuration to be simplified.

Further, in this embodiment, the memory cell matrix 1 may be constructed so as to include MOS transistors having sources connected to the data lines, respectively and drains connected to the word lines, respectively.

Figure 5 is another embodiment of voltage reducing circuit 101 having a constant voltage characteristic. In Figure 5, the voltage reducing circuit 101 comprises a load depletion type MOS FET 141 and a MOS FET 142 serially connected with each other between the high supply voltage Vcc and the low supply voltage Vss, a MOS FET 143 disposed between a drain of the MOS FET 141 and a gate of the MOS FET 142 parallel to them. Further, a gate of the MOS FET 143 is connected with a source of the MOS FET 141. Since the MOS FET 143 serves to reduce voltage, a stable middle voltage between the supply voltages VCC and Vss is produced on the source of the MOS FET 143, and provided to common lines 5-1, 5-2, ...., 5-m.

The read and sense circuit 106 in Figure 2 does not require an external reference voltage, and enables any data to be precisely read out.

Thus, in the read and sense circuit 106 of the present embodiment, it is possible to detect the amount of inflow current flowing into the Vss potential from the data lines 4-1, 4-2, ...., 4-n having a potential extremely close to the low supply potential Vss (for example 0V) of an integrated circuit driven by a signal power source of the high power source potential Vcc (for example 5V). Actually, it is easy to lower the data lines 4-1, 4-2, 4-n to several tens of mV for the potential close to the Vss described above. The date lines 4-1, 4-2, ...., 4-n can rapidly return to the detection potential thereof even if a temporary excess current flows into them.

In such a manner, even if the detection potential of the data lines 4-1, 4-2, ...., 4-n serving to read out data is close to the low supply voltage Vss, an inflow current from the data lines can be effectively detected. Accordingly, it is possible to apply a middle potential between the supply voltages Vcc and Vss to the common lines 5-1, 5-2, ...., 5-m, and to raise the potential of non-selected data line near to the Vss. Hereby, the potential of the non-selected data lines can be prevented from dropping to Vss. Consequently, the load capacitance of the word lines 3-1, 3-2, ...., 3-m can be reduced and thereby the read rate improved.

In addition, when in Figure 2, the characteristics of the MOS FETs 131 and 141 are made the same and the current drive capability of the depletion type MOS FET 133 is made lower than that of the depletion type MOS FET 143 the same effect as the above can be predicted. Further, even when the gates of the MOS FETs 132 and 143 are connected with each other and the gate of the MOS FET 141 and drain of the MOS FET 142 are connected, while the former is not connected with the latter, the same effect is seen. Moreover, direct application of the voltage Vcc to the common lines 5-1, 5-2, ...., 5-m without employing the constant voltage circuit 101 will do.

Figures 6 and 7 show another embodiment of the current sense circuit 240 according to the present invention.

The current sense circuit 240 of Figure 6 comprises the MOS FETs 131, 141, the MOS FETs 132, 142, and the MOS FETs 133, 143, which are constructed of transistors having the same characteristics. A reference current $I_{ref}$ is made to flow into the connection point between the MOS FETs 141 and 142, and thereby an inflow current from the input line 105 is detected. Even with such arrangement, the same effect as with the second embodiment can be anticipated.

In addition, in the current sense circuit 240 of Figure 7, an example is shown, in which the detector of Figure 6 is constructed with CMOS transistors. The circuit is constructed with the same number of elements as in Figure 6, and thereby can exert the same function.

With the arrangement of a ROM according to the present invention, current flows, during the read operation, from at least one selected data line among a plurality of the data lines into the read and sense circuit. The reader detects the memory state of a selected memory cell based on the inflow amount of the current. Accordingly, a non-selected memory cell does not contribute to word line load capacitance, and the word line load capacitance upon switching word lines can be reduced. Thus, the signal transfer rate can be increased, and the data read rate speeded up.

In addition, according to the read and sense circuit of the ROM of the present invention, the first and third MOS transistors and the first current supply means, and the second and fourth MOS transistors and the second current supply means are associated with each other, and respectively connected in series between the low supply voltage and high supply voltage. Accordingly, the input side of the ROM can be kept at a stabilised low potential, and information stored in a memory element can be read out based on the inflow current from the input side. Moreover, the low supply voltage is applied to the read and sense circuit of the data line while the high supply voltage is applied to the opposite side of the data line. Thus, the selected data line potential can be kept at a low potential, while the non-selected data lines can be raised. Hereby, it is possible to prevent the non-selected data line potential from dropping to a lower potential. Thus, word line load capacitance can be reduced, and thereby the read rate improved.

**Claims**

1. A MOS ROM system comprising:-

(a) a memory matrix (1) having a plurality of memory cells (2-11--2-mn), a plurality of data lines (4-1--4-n) and a plurality of word lines (3-1--3-m), said data lines (4-1--4-n) and said word lines (3-1--3-m) being arranged in a matrix form, said memory cells (2-11--2-mn) each being formed of a MOS transistor which has a gate electrode connected to said word line, a source electrode connected to said data line and a drain electrode connected to a common line (5);

(b) a word line decoder (7) for selecting one of said word lines (3-1--3-m) in response to a column address signal (11) to activate a selected MOS transistor;

(c) a multiplexer (8) including a plurality of MOS switching transistors (14-1--14-n) being connected to said data lines (4-1--4-n) of said memory matrix;

(d) a data line decoder (9) for activating one of said MOS switching transistors (14-1--14-n) in response to a row address signal (12) to select one of said data lines (4-1--4-n);

(e) a read and sense circuit (106) connected to said multiplexer (8); said system being characterised by:

(f) a power supply means (101) connected to said common line (5) of said memory matrix for providing a first potential; and

(g) load means (103) connected between said data line and said power supply means for suppressing the voltage drop of said data line;

and in that said read and sense circuit (106) has a sense node (105) at a second potential lower than said first potential, said sense node being connected to said multiplexer (8) for amplifying a detection current passing through a selected MOS transistor of said memory matrix to deliver a data signal.

2. A MOS ROM system according to claim 1, wherein said read and sense circuit (106) comprises a converter (130) for converting said data detection current into voltage, a reference voltage circuit (140) for generating a reference voltage, a differential amplifier (150) for amplifying the output difference between said converter (130) and said reference voltage circuit (140) and an output circuit for amplifying the output signal from said differential amplifier (150) to deliver said data signal to a data output terminal.

3. A MOS ROM system according to claim 1, wherein said power supply means include a voltage reducing circuit (101) for lowering said first potential to allow said MOS transistor in said memory matrix to operate at a higher rate.

4. A MOS ROM system according to claim 1, wherein said read and sense circuit comprises:-

a first MOS transistor (131) having a first and second electrode and a control electrode for converting an input current to voltage;

a second MOS transistor (141) having a first and second electrode and a control electrode for serving as a constant voltage circuit;

said first electrodes of said first and second MOS transistors being connected with a low power source (VSS), said second potential being higher than that of the low power source;

a third MOS transistor (132) having first and second electrodes and a control electrode for converting said input current to said voltage;

said first electrode of said third MOS transistor (132) being connected with said second electrode of said first MOS transistor and said second electrode of the third MOS transistor being connected with said control electrode of said first MOS transistor;

a fourth MOS transistor (142) having first and second electrodes and a control electrode for serving as a constant voltage circuit;

said first electrode of said fourth MOS transistor being connected with said second electrode of said second MOS transistor, said second electrode of said fourth MOS transistor being connected with said control electrode of said second MOS transistor and said control electrode of said fourth MOS transistor being connected with said control electrode of said third MOS transistor;

a first current supply means (133) for supplying a current from a high voltage power supply to said second electrode of said third MOS transistor and converting an input current to voltage; and

a second current supply means (143) for supplying a current from said high voltage power supply to said second electrode of said fourth MOS transistor, the arrangement being such that said first and third MOS transistors and said first current supply means, and said second and fourth MOS transistors and said second current supply means are adapted to keep the input side at stabilised low potential, whereby current from the selected memory element is allowed to flow into said read and sense circuit and any information stored in said memory element is read out based on the amount of said inflow current.

## Revendications

1. Un système de mémoire morte de type MOS comprenant :

(a) une matrice de mémoire (1) ayant un ensemble de cellules de mémoire (2-11, ... 2-mn), un ensemble de lignes de données (4-1, ... 4-n) et un ensemble de lignes de mot (3-1, ... 3-m), les lignes de données (4-1, ... 4-n) et les lignes de mot (3-1, ... 3-m) étant disposées sous une forme matricielle, chacune de ces cellules de mémoire (2-11, ... 2-mn), étant constituée par un transistor MOS qui comporte une électrode de grille connectée à la ligne de mot, une électrode de source connectée à la ligne de données et une électrode de drain connectée à une ligne commune (5);

(b) un décodeur de ligne de mot (7) qui est destiné à sélectionner l'une des lignes de mot (3-1, ... 3-m) sous la dépendance d'un signal d'adresse de colonne (11), pour activer un transistor MOS sélectionné ;

(c) un multiplexeur (8), comprenant un ensemble de transistors de commutation MOS (14-1, ... 14-n), qui sont connectés aux lignes de données (4-1, ... 4-n) de la matrice de mémoire ;

(d) un décodeur de ligne de données (9) qui est destiné à activer l'un des transistors de commutation MOS (14-1, ... 14-n), sous la dépendance d'un signal d'adresse de rangée (12), pour sélectionner l'une des lignes de données (4-1, ... 4-n) ;

(e) un circuit de lecture et de détection (106) connecté au multiplexeur (8) ;

ce système étant caractérisé par :

(f) des moyens d'alimentation (101) connectés à la ligne commune (5) de la matrice de mémoire, pour établir un premier potentiel ; et

(g) des moyens de charge (103) connectés entre la ligne de données et les moyens d'alimentation, pour réduire la chute de tension de la ligne de données ;

et en ce que le circuit de lecture et de détection (106) comporte un noeud de détection (105) qui est à un second potentiel, inférieur au premier potentiel, ce noeud de détection étant connecté au multiplexeur (8) pour amplifier un courant de détection qui passe par un transistor MOS sélectionné de la matrice de mémoire, pour fournir un signal de données.

2. Un système de mémoire morte de type MOS selon la revendication 1, dans lequel le circuit de lecture et de détection (106) comprend un convertisseur (130) qui est destiné à convertir le courant de détection de données en une tension, un circuit de tension de référence (140) qui est destiné à générer une tension de référence, un amplificateur différentiel (150) qui est destiné à amplifier la différence de sortie entre le convertisseur (130) et le circuit de tension de référence (140), et un circuit de sortie qui est destiné à amplifier le signal de sortie provenant de l'amplificateur différentiel (150), pour appliquer le signal de données à une borne de sortie de données.

3. Un système de mémoire morte MOS selon la revendication 1, dans lequel les moyens d'alimentation comprennent un circuit de réduction de tension (101) qui est destiné à abaisser le premier potentiel, pour permettre au transistor MOS dans la matrice de mémoire de fonctionner à une cadence plus élevée.

4. Un système de mémoire morte de type MOS selon la revendication 1, dans lequel le circuit de lecture et de détection comprend :

un premier transistor MOS (131) ayant des première et seconde électrodes et une électrode de commande, pour convertir un courant d'entrée en une tension ;

un second transistor MOS (141) ayant des première et seconde électrodes et une électrode de commande, pour fonctionner en circuit à tension constante ;

les premières électrodes des premier et second transistors MOS étant connectées à une source d'énergie de niveau bas (VSS), et le second potentiel étant plus élevé que celui de la source d'énergie de niveau bas ;

un troisième transistor MOS (132) ayant des première et seconde électrodes et une électrode de commande, pour convertir le courant d'entrée de façon à donner la tension précitée ;

la première électrode du troisième transistor MOS (132) étant connectée à la seconde électrode du premier transistor MOS, et la seconde électrode du troisième transistor MOS étant connectée à l'électrode de commande du premier transistor MOS ;

un quatrième transistor MOS (142) ayant des première et seconde électrodes et une électrode de commande, pour remplir la fonction d'un circuit à tension constante ;

la première électrode du quatrième transistor MOS étant connectée à la seconde électrode du second transistor MOS, la seconde électrode du quatrième transistor MOS étant connectée à l'électrode de commande du second transistor MOS, et l'électrode de commande du quatrième transistor MOS étant connectée à l' électrode de commande du troisième transistor MOS ;

une première source de courant (133) destinée à fournir un courant qui circule d'une alimentation à tension élevée vers la seconde électrode du troisième transistor MOS, et à convertir un courant d'entrée en une tension ; et

une seconde source de courant (143) destinée à fournir un courant qui circule de l'alimentation à tension élevée vers la seconde électrode du quatrième transistor MOS, la configuration étant telle que les premier et troisième transistors MOS et la première source de courant, et les second et quatrième transistors MOS et la seconde source de courant maintiennent le côté d'entrée à un potentiel bas stabilisé, grâce à quoi le courant qui provient de l'élément de mémoire sélectionné peut entrer dans le circuit de lecture et de détection, et une information quelconque qui est enregistrée dans l'élément de mémoire est lue sur la base de la valeur de ce courant entrant.

**Patentansprüche**

1. MOS-ROM-System, das aufweist:

(a) eine Speichermatrix (1) mit einer Vielzahl von Speicherzellen (2-11--2-mn), einer Vielzahl von Datenleitungen (4-1--4-n) und einer Vielzahl von Wortleitungen (3-1--3-m), wobei die Datenleitungen (4-1--4-n) und die Wortleitungen (3-1--3-m) in Matrizenform angeordnet und die Speicherzellen (2-11--2-mn) jeweils aus einem MOS-Transistor gebildet sind, der eine mit der Wortleitung verbundene Gateelektrode, eine mit der Datenleitung verbundene Sourceelektrode und eine mit einer gemeinsamen Leitung (5) verbundene Drainelektrode hat;

(b) einen Wortleitungs-Dekodierer (7) zum Auswählen einer der Wortleitungen (3-1--3-m) zur Aktivierung eines ausgewählten MOS-Transistors in Antwort auf ein Spaltenadressierungssignal (11);

(c) einen Multiplexer (8), der eine Vielzahl von mit den Datenleitungen (4-1--4-n) der Speichermatrix verbundenen MOS-Schalttransistoren (14-1--14-n) aufweist;

(d) einen Datenleitungs-Dekodierer (9) zur Aktivierung eines der MOS-Schalttransistoren (14-1--14-n) in Antwort auf ein Zeilenadressierungssignal (12), um eine der Datenleitungen (4-1--4-n) auszuwählen;

(e) eine mit dem Multiplexer (8) verbundene Lese- und Prüfschaltung (106); wobei das System gekennzeichnet ist durch:

(f) eine mit der gemeinsamen Leitung (5) der Speichermatrix verbundene Stromversorgungseinrichtung (101) zum Erzeugen eines ersten Potentials; und

(g) eine zwischen der Datenleitung und der Stromversorgungseinrichtung angeschlossene Lasteinrichtung (103) zur Unterdrückung des Spannungsabfalls der Datenleitung; und dadurch, daß die Lese- und Prüfschaltung (106) einen Prüfknoten (105) auf einem zweiten Potential hat, das niedriger als das erste Potential ist, wobei der Prüfknoten zur Verstärkung eines Erkennungsstroms, der zur Abgabe eines Datensignals durch einen ausgewählten MOS-Transistor der Speichermatrix fließt, mit dem Multiplexer (8) verbunden ist.

2.  MOS-ROM-System nach Anspruch 1, worin die Lese- und Prüfschaltung (106) einen Wandler (130) zur Umwandlung des Datenerkennungsstroms in Spannung, eine Referenzspannungs-Schaltung (140) zur Erzeugung einer Referenzspannung, einen Differenzverstärker (150) zur Verstärkung der Ausgangsdifferenz zwischen dem Wandler (130) und der Referenzspannungs-Schaltung (140) und eine Ausgangsschaltung zur Verstärkung des Ausgangssignals des Differenzverstärkers (150) zur Abgabe des Datensignals an ein Datenausgabeterminal aufweist.

3.  MOS-ROM-System nach Anspruch 1, worin die Stromversorgungseinrichtung eine Spannungsreduzierungsschaltung (101) zum Absenken des ersten Potentials, so daß der MOS-Transistor in der Speichermatrix mit einer höheren Geschwindigkeit arbeiten kann, aufweist.

4.  MOS-ROM-System nach Anspruch 1, worin die Lese- und Prüfschaltung aufweist:

einen ersten MOS-Transistor (131) mit einer ersten und zweiten Elektrode und einer Steuerelektrode zum Umwandeln eines Eingangsstroms in Spannung;

einen zweiten MOS-Transistor (141) mit einer ersten und zweiten Elektrode und einer Steuerelektrode, der als Konstantspannungs-Schaltung dient;

wobei die ersten Elektroden des ersten und zweiten MOS-Transistors mit einer Niederleistungsquelle (VSS) verbundenen sind und das zweite Potential höher als das der Niederleistungsquelle ist;

einen dritten MOS-Transistor (132) mit ersten und zweiten Elektroden und einer Steuerelektrode zum Umwandeln des Eingangsstroms in Spannung;

wobei die erste Elektrode des dritten MOS-Transistors (132) mit der zweiten Elektrode des ersten MOS-Transistors und die zweite Elektrode des dritten MOS-Transistors mit der Steuerelektrode des ersten MOS-Transistors verbunden ist;

einen vierten MOS-Transistor (142) mit ersten und zweiten Elektroden und einer Steuerelektrode, der als Konstantspannungs-Schaltung dient;

wobei die erste Elektrode des vierten MOS-Transistors mit der zweiten Elektrode des zweiten MOS-Transistors, die zweite Elektrode des vierten MOS-Transistors mit der Steuerelektrode des zweiten MOS-Transistors und die Steuerelektrode des vierten MOS-Transistors mit der Steuerelektrode des dritten MOS-Transistors verbunden ist;

eine erste Stromzuführeinrichtung (133) zum Zuführen eines Stroms von einer Hochspannungs-Stromversorgungseinheit zur zweiten Elektrode des dritten MOS-Transistors und zum Umwandeln eines Eingangsstroms in Spannung; und

eine zweite Stromzuführeinrichtung (143) zum Zuführen eines Stroms von der Hochspannungs-Stromversorgungseinheit zur zweiten Elektrode des vierten MOS-Transistors, wobei die Anordnung so ist, daß der erste und dritte MOS-Transistor und die erste Stromzuführeinrichtung, und der zweite und vierte MOS-Transistor und die zweite Stromzuführeinrichtung so ausgelegt sind, daß sie die Eingangsseite auf einem stabilisierten niedrigen Potential halten, wodurch Strom von dem ausgewählten Speicherelement in die Lese- und Prüfschaltung fließen kann und jegliche in dem Speicherelement gespeicherte Information auf der Basis der Stärke des einfließenden Stroms ausgelesen wird.

Fig. I

# Fig. 2

# Fig. 3

11

# Fig. 4

# Fig. 5

# Fig. 6

FROM DATA LINE
CONNECTED WITH
DUMMY CELL
TRANSISTORS

# Fig. 7

FROM DATA LINE
CONNECTED WITH
DUMMY CELL
TRANSISTORS